**Europäisches Patentamt**

**European Patent Office**

**Office européen des brevets**

(19)

(11) Veröffentlichungsnummer : **0 038 029**
**B1**

(12) **EUROPÄISCHE PATENTSCHRIFT**

(45) Veröffentlichungstag der Patentschrift :
**18.01.84**

(21) Anmeldenummer : **81102695.4**

(22) Anmeldetag : **09.04.81**

(51) Int. Cl.³ : **G 03 C   1/68**

(54) **Photopolymerisierbare Mischung mit einem Copolyamid, Monomeren und Photoinitiator.**

(30) Priorität : **16.04.80 DE 3014579**

(43) Veröffentlichungstag der Anmeldung :
**21.10.81 Patentblatt 81/42**

(45) Bekanntmachung des Hinweises auf die Patenterteilung : **18.01.84 Patentblatt 84/03**

(84) Benannte Vertragsstaaten :
**BE CH DE FR GB IT LI NL**

(56) Entgegenhaltungen :
**DE-A- 1 522 441**
**FR-A- 1 488 580**

(73) Patentinhaber : **BASF Aktiengesellschaft**
**Carl-Bosch-Strasse 38**
**D-6700 Ludwigshafen (DE)**

(72) Erfinder : **Horn, Peter, Dr.**
**Neue Stuecker 15**
**D-6900 Heidelberg (DE)**
Erfinder : **Cordes, Claus, Dr.**
**Halbergstrasse 13**
**D-6719 Weisenheim (DE)**
Erfinder : **Werther, Heinz-Ulrich, Dr.**
**Hans-Hoffmann-Strasse 12**
**D-6706 Wachenheim (DE)**
Erfinder : **Zuerger, Manfred**
**Holderlandstrasse 2**
**D-6920 Sinsheim-Dueren (DE)**
Erfinder : **Reimann, Horst, Dr.**
**Adelheidstrasse 26**
**D-6520 Worms (DE)**

Photopolymerisierbare Mischung mit einem Copolyamid, Monomeren und Photoinitiator

Die Erfindung betrifft für die Herstellung von Kunststoffschichten aus Lösungen besonders geeignete photopolymerisierbare Mischungen, die neben ethylenisch ungesättigten Monomeren und photoinitiatoren spezielle in einem alkoholischen Lösungsmittel lösliche Copolyamide als polymere Bindemittel enthalten.

Es ist z. B. aus der DE-A 15 22 463 bekannt, für die Herstellung von Reliefschichten, Dekorations- und Druckplatten photopolymerisierbare Mischungen zu verwenden, die ein lösliches Copolyamid, ethylenisch ungesättigte Monomere und Photoinitiator(en) enthalten. Die Mischungen werden durch entsprechende verfahrenstechnische Maßnahmen wie Spritzen, Kalandrieren, Extrudieren und Gießen in die gewünschte Form gebracht. Die Mischungen können unter anderem in Lösungsmitteln, in welchen die Systeme löslich sind, hergestellt und verarbeitet werden. Für die Verarbeitung ist die Art des löslichen Copolyamids von wesentlicher Bedeutung.

Photopolymerisierbare Schichten können aus Lösungen der Schichtbestandteile durch Gießen hergestellt werden. Hierzu werden die erforderlichen Mischungskomponenten in einem Lösungsmittel bzw. Lösungsmittelgemisch gegebenenfalls unter Anwendung von Wärme aufgelöst. Als Lösungsmittel kommen für photopolymerisierbare Mischungen von löslichen Copolyamiden mit Monomeren und ggf. Photoinitiatoren besonders aliphatische primäre Alkohole mit 1-3 C-Atomen gegebenenfalls im Gemisch mit Wasser sowie Toluol in Frage. Aus solchen z. B. chargenweise oder nach einem kontinuierlichen Verfahren z. B. auf ein Trägermaterial gegossenen Schichten muß anschließend das Lösungsmittel entfernt werden. Dieser Trocknungsprozeß ist meist der geschwindigkeits- und kapazitätsbegrenzende Schritt im Herstellungs verfahren. Die erforderliche Zeit für die Trocknung wird durch die Trocknungstemperatur und durch die zu verdampfende Lösungsmittelmenge wesentlich beeinflußt. Die Verdampfungstemperatur ist durch den Siedebereich des Lösungsmittels bzw. des Lösungsmittelgemisches sowie durch die thermische Instabilität einzelner Komponenten der Mischung nach oben begrenzt. Die zu verdampfende Lösungsmittelmenge wird durch die Feststoffgehalte der Gießlösung und die verfahrens- und anwendungsbedingte maximal zulässige Restfeuchte (Restlösungsmittelmenge) in der Schicht gegeben. In der Regel müssen diese kleiner als 15 Gew.% vorzugsweise kleiner als 5 Gew.% bezogen auf die Schicht sein. Die Feststoffgehalte der Gießlösung liegen bisher unterhalb von 70 Gew.%, das entspricht Konzentrationen an löslichen Copolyamiden in den Gießlösungen von maximal 40-50 Gew.%. Die Einstellung von Feststoffgehalten in der Gießlösung von über 70 Gew.% hinaus gelingt mit den bisher in der Technik verwendeten Copolyamiden nicht. Bei Feststoffgehalten größer als 70 Gew.% tritt bei den nach dem Stand der Technik verwendeten Copolyamiden ein rascher Viskositätsanstieg der Lösung (Gelierung) auf, die eine einwandfreie Verarbeitung zu gleichmäßigen Schichten nicht mehr zuläßt.

Der Erfindung lag die Aufgabe zugrunde, für die Herstellung von Kunststoffschichten aus Lösung geeignete photopolymerisierbare Copolyamid-Monomer-Mischungen zu finden, die sich aus Lösungen mit hohen Feststoffgehalten günstig verarbeiten lassen.

Es wurde nun gefunden, daß die Aufgabe gelöst werden kann mit einer photopolymerisierbaren Mischung mit einem in einem alkoholischen Lösungsmittel löslichen Copolyamid als polymerem Bindemittel, mindestens einem ethylenisch ungesättigten Monomeren mit mindestens einer photopolymerisierbaren C-C-Doppelbindung und mindestens einem Photoinitiator, die dadurch gekennzeichnet ist, daß sie als Copolyamid ein aus

28 bis 35 Gew.% ε-Caprolactam
35 bis 42 Gew.% Adipinsäure-Hexamethylendiamin-Salz
22 bis 27 Gew.% Adipinsäure-2,2-Bis(4-aminocyclohexyl)-propan-Salz und
4 bis 11 Gew.% Decandicarbonsäure(1, 10)-2,2-Bis(4-aminocyclohexyl)-propan-Salz

hergestelltes Copolyamid mit einem K-Wert nach Fikentscher (Cellulosechemie 13 (1932) 58), gemessen als 1 gew.%ige Lösung in 96 %iger Schwefelsäure, von 58 bis 68 enthält.

Mit den erfindungsgemäßen Copolyamid-Mischungen erzielt man bei der Herstellung von Schichten und Platten aus Lösungen wesentliche Vorteile. Im Gegensatz zu dem bisherigen Verfahren kann man mit Gießlösungen der erfindungsgemäßen Mischungen mit einem Feststoffgehalt von über 70 Gew.%, entsprechend Polyamid-Konzentrationen von oberhalb 40 bzw. 50 Gew.%, arbeiten. Die so hergestellten Gießlösungen sind auch bei diesen hohen Konzentrationen über längere Zeiten stabil und neigen nicht zum Gelieren. Im Gegensatz zu den Gießlösungen auf Basis der handelsüblichen sowie der in der DE-A 1 522 463 beschriebenen Copolyamide zeigen Lösungen der erfindungsgemäßen Mischungen bei konstantem Feststoffgehalt und konstanter Temperatur in Abhängigkeit von der Zeit sehr geringe Viskositätsänderungen. Mit den erfindungsgemäßen Mischungen können Schichten und Platten aus höher konzentrierten Gießlösungen und mit deutlich günstigeren Trockenzeiten einwandfrei hergestellt werden.

Die Copolyamide für die erfindungsgemäßen Mischungen können nach bekannten Methoden hergestellt werden, ein Beispiel einer Herstellung ist nachstehend gegeben.

Das Verhältnis von Copolyamiden zu ethylenisch ungesättigten Monomeren in der Mischung richtet sich nach dem Verwendungszweck der aus der Mischung hergestellten Schichten. Als zweckmäßig haben sich Mengen von 50 bis 90 Gew.% an Copolyamid und 10 bis 50 Gew.% an Monomeren erwiesen, bezogen auf die Summe der Menge an Copolyamid und Monomeren.

Als Monomere eignen sich vor allem solche, die mit den Copolyamiden und Zusätzen verträgliche Mischungen bilden. Beispiele geeigneter Monomerer sind in der DE-A 15 22 463 angeführt, worauf diesbezüglich ausdrücklich Bezug genommen wird.

Der oder die Photoinitiatoren sind in den Mischungen in üblichen Mengen enthalten, zweckmäßig in einer Menge von 0,01 bis 10 und insbesondere 0,01 bis 5 Gew.% der Gesamtmischung. Geeignete Photoinitiatoren sind dem Fachmann geläufig.

Den Mischungen können in an sich bekannter Weise Zusätze wie Inhibitoren, Weichmacher oder Farbstoffe in an sich üblichen Mengen zugemischt werden.

Die Vernetzung bzw. Photopolymerisation der aus den erfindungsgemäßen Mischungen hergestellten Schichten kann in bekannter Weise durch Belichten mit energiereichen Lampen wie Kohlenbogenlampen, Quecksilberdampflampen, Hexonlampen, Leuchtstoffröhren oder UV-Laser erfolgen. Die erfindungsgemäßen Mischungen und die daraus hergestellten Schichten finden Verwendung, z. B. bei der Herstellung von Reliefschichten, Druckplatten oder Dekorationsschichten.

Die in den nachstehenden Versuchen und dem Beispiel genannten Teile und Prozente beziehen sich auf das Gewicht.

Herstellung eines Copolyamids für die erfindungsgemäßen Mischungen

40 Teile eines Salzes aus äquimolaren Mengen von Adipinsäure und Hexamethylendiamin-(1,6), 30 Teile ε-Caprolactam, 25 Teile eines Salzes aus äquimolaren Mengen von Adipinsäure und 2,2-bis(4-aminocyclohexyl)-propan, 5 Teile eines Salzes aus äquimolaren Mengen von Decandicarbonsäure-(1,10) und 2,2-Bis(4-aminocyclohexyl)-propan sowie 20 Teile Wasser werden bei 280 °C und einem Druck von 20 bar 2 Stunden vorkondensiert. Danach wird über einen Zeitraum von 1 Stunde auf Normaldruck entspannt und anschließend 2 Stunden bei 280 °C im Stickstoffstrom nachkondensiert. Das so hergestellte Copolyamid wird in Strängen ausgetragen und granuliert. Der K-Wert des erhaltenen Copolyamids (gemessen als 1 %ige Lösung in 96 %iger Schwefelsäure) beträgt 61.

Beispiel

55 Teile des wie vorstehend beschrieben hergestellten Copolyamids werden zusammen mit 30 Teilen 1,1,1-Trimethylolpropantriacrylat, 12 Teilen p-Toluolsulfonamid, 1,5 Teilen Benzoinisopropyläther und 0,2 Teilen tert.-Butylkresol in 20 Teilen Methanol und 10 Teilen Wasser bei 60 °C unter Rühren gelöst. Die Lösung zeigt bei 60 °C eine Viskosität von 2 000 mPa.s und ändert sich bei Lagerung der Lösung bei 60 °C über einen Zeitraum von 3 Stunden nicht. Nach einer Aufkonzentrierung auf einen Feststoffgehalt von 75 % beträgt die Viskosität bei 60 °C 79 000 mPa.s und ändert sich bei dieser Temperatur über einen Zeitraum von 4 Stunden nicht. Aus der Lösung können durch Gießen einwandfreie und gleichmäßige Schichten hergestellt werden, aus denen das restliche Lösungsmittel einfach und rasch entfernt werden kann.

Vergleichsversuch

Aus 55 Teilen eines handelsüblichen Copolyamids aus 35 % eines Salzes aus äquimolaren Mengen von Adipinsäure und Hexamethylendiamin-(1,6), 30 % ε-Caprolactam und 35 % des Salzes aus äquimolaren Mengen von Adipinsäure und Bis(4-amino-cyclohexyl)-methan mit einem K-Wert von 65 wird gemäß Beispiel 1 eine Lösung hergestellt. Diese Lösung zeigt bei 60 °C eine Viskosität von 2 000 mPa.s die sich bei Lagerung bei 60 °C innerhalb von 3 Stunden nicht ändert. Diese Lösung wird in einem Rotationsverdampfer bei Normaldruck auf 70 % Feststoffgehalt aufkonzentriert. Die aufkonzentrierte Lösung zeigt bei 60 °C eine Viskosität von 41 000 mPa.s, die über einen Zeitraum von 3 Stunden bei 60 °C durch einsetzende Gelierung auf 63 000 mPa.s ansteigt. Nach einer Lagerzeit von 4 Stunden können wegen der Gelbildung mit dieser Lösung keine gleichmäßigen Schichten mehr gegossen werden.

**Anspruch**

Photopolymerisierbare Mischung mit einem in einem alkoholischen Lösungsmittel löslichen Copolyamid als polymeren Bindemittel, mindestens einem ethylenisch ungesättigten Monomeren mit mindestens einer photopolymerisierbaren C-C-Doppelbindung und mindestens einem Photoinitiator, dadurch gekennzeichnet, daß sie als Copolyamid ein aus 28 bis 35 Gew.% ε-Caprolactam, 35 bis 42 Gew.% Adipinsäure-Hexamethylendiamin-Salz, 22 bis 27 Gew. % Adipinsäure-2,2-Bis(4-aminocyclohexyl)-propan-Salz und 4 bis 11 Gew.% Decandicarbonsäure-(1,10)-2,2-Bis(4-aminocyclohexyl)-propan-Salz hergestelltes Copolyamid mit einem K-Wert nach Fikentscher von 58 bis 68 enthält.

**Claim**

A photopolymerizable composition containing, as polymeric binder, a copolyamide which is soluble in an alcoholic solvent; at least one ethylenically unsaturated monomer having at least one photopolymerizable carbon-carbon double bond; and at least one photoinitiator, which contains, as the copolyamide, a copolyamide which has a K value according to Fikentscher of 58 to 68, and has been prepared from 28 to 35 % by weight of ε-caprolactam, 35 to 42 % by weight of the salt of adipic acid and hexamethylenediamine, 22 to 27 % by weight of the salt of adipic acid and 2,2-bis(4-aminocyclohexyl)-propane, and 4 to 11 % by weight of the salt of 1,10-decanedicarboxylic acid and 2,2-bis(4-aminocyclohexyl)-propane.

**Revendication**

Mélange photopolymérisable comprenant, comme liant polymère, un copolyamide soluble dans un solvant alcoolique, au moins un monomère à insaturation éthylénique et à au moins une double liaison C-C photopolymérisable, et au moins un photoinitiateur, caractérisé par le fait qu'il contient, comme copolyamide, un copolyamide d'un indice K, selon Fikentscher, de 58 à 68, préparé à partir de 28 à 35 % en poids de ε-caprolactame, 35 à 42 % en poids d'un sel d'acide adipique et hexaméthylènediamine, 22 à 27 % en poids, d'un sel d'acide adipique et 2,2-bis(4-aminocyclohexyl)-propane et 4 à 11 % en poids d'un sel d'acide decandicarboxylique et (1,10)-2,2-bis(4-aminocyclohexyl)-propane.